## Europäisches Patentamt
## European Patent Office
## Office européen des brevets

(19)

(11) Veröffentlichungsnummer: **0 004 321**
**B1**

(12) **EUROPÄISCHE PATENTSCHRIFT**

(45) Veröffentlichungstag der Patentschrift:
28.10.81

(21) Anmeldenummer: 79100707.3

(22) Anmeldetag: 08.03.79

(51) Int. Cl.³: **G 01 R 15/07,** G 02 F 1/09, G 02 F 2/00

(54) **Verfahren zur magnetooptischen Strommessung.**

(30) Priorität: 20.03.78 DE 2812188

(43) Veröffentlichungstag der Anmeldung:
03.10.79 Patentblatt 79/20

(45) Bekanntmachung des Hinweises auf die Patenterteilung:
28.10.81 Patentblatt 81/43

(84) Benannte Vertragsstaaten:
BE CH FR GB SE

(56) Entgegenhaltungen:
DE-B-2 236 251
FR-A-1 252 209
US-A-2 974 561
US-A-3 312 141
US-A-3 483 388

(73) Patentinhaber: SIEMENS AKTIENGESELLSCHAFT Berlin und München, Postfach 22 02 61, D-8000 München 22 (DE)

(72) Erfinder: Papp, Alfred, Dr., Winternitzstrasse 6, D-8000 München (DE)

EP 0 004 321 B1

## Verfahren zur magnetooptischen Strommessung

Die Erfindung bezieht sich auf ein Verfahren zur magnetooptischen Strommessung mit einer vom Strom abhängigen Drehung der Polarisationsebene eines linear polarisierten Lichtstrahls, dem eine hochfrequente Modulationsdrehung überlagert wird, wobei die Gesamtdrehung in eine Intensitätsänderung des Lichtstrahls und diese wieder in ein elektrisches Messignal umgesetzt wird.

Es sind Einrichtungen zur Messung von Strömen in Hochspannungsleitern und zur Messung grosser Wechselströme mit Gleichstromglied bekannt, bei denen ein linear polarisierter Strahl über einen magnetooptischen Modulator sowie einen Analysator einem Detektor zugeführt wird, dem eine Elektronik nachgeschaltet ist. Die Polarisationsebene des Lichtstrahls wird in dem vom magnetischen Feld des zu messenden Stromes beeinflussten Modulator entsprechend der Grösse des Stromes gedreht. In einer auf Niederspannungspotential angeordneten Auswerteeinrichtung wird im Analysator die Grösse der Drehung in ein entsprechendes Intensitätssignal umgewandelt, das vom Photodetektor erfasst werden kann. Das Ausgangssignal des Detektors wird in der Elektronik verarbeitet.

In einer bekannten Anordnung (DE-C-2130047) enthält die Auswerteeinrichtung einen zusätzlichen magnetooptischen Modulator und eine Verstärkerschaltung. Der zusätzliche Modulator besteht aus der Spule eines Lichtwellenleiters und aus einer auf die Spule aufgebrachten, von der Verstärkerschaltung mit Strom gespeisten elektrischen Wicklung. Dem zusätzlichen Modulator ist der Analysator nachgeschaltet, in dem das vom Modulator kommende Licht in zwei Teillichtstrahlen aufgespalten wird, deren Polarisationsebenen senkrecht aufeinander stehen und die ihre Intensität proportional zum Drehwinkel der Polarisationsebene des einfallenden Strahls gegenläufig ändern. Die beiden Teillichtstrahlen werden jeweils einem Detektor zugeführt, die vorzugsweise Halbleiterphotodioden sein können und denen ein Differenzverstärker nachgeschaltet ist. Die Differenzspannung dient als Mass für die Faraday-Drehung des Messignals. Mit diesem Differential-Messverfahren können die Rauschanteile des Messignals, die durch Intensitätsschwankungen des Lichtstrahls, der vorzugsweise ein Laserstrahl sein kann, verursacht werden, nicht eliminiert werden. In einem technischen Aufbau ist es ausserdem unvermeidlich, dass die Laserstrahlen auf den Halbleiterphotodioden örtlich schwanken. Da die Photoempfindlichkeit dieser Dioden ortsabhängig ist, können Strahlverlagerungen von wenigen µm Signalschwankungen bis zu mehreren Prozent verursachen. Darüber hinaus zeigen solche Photodioden eine geringe Exemplarstreuung ihrer Empfindlichkeit. Die den beiden Teilstrahlen zugeordneten Detektoren liefern somit unterschiedliche Signalschwankungen, die mit diesem Verfahren nicht eliminiert werden können.

Ein weiteres bekanntes Verfahren (Rogers in «Optical Methods for Measurement of Voltage and Current at High Voltage», A.I.M., Liege, Traitement des données – 1977) arbeitet deshalb mit einem modulierten Lichtstrahl, der über den Messfühler und einen Analysator einer einzigen Photodiode zugeführt wird, deren Ausgangssignal in einer Elektronik verarbeitet wird.

Der Modulator erzeugt eine periodische Drehung $\Delta$ (t) der Polarisationsebene, der im Messfühler eine zusätzliche Drehung entsprechend der Grösse des vom zu messenden Strom erzeugten Magnetfeldes hinzugefügt wird. Das von der Photodiode registrierte Signal enthält einen Rauschanteil, weil alle Schwankungen der Lichtintensität I (t) das Nutzsignal verändern. Die wesentlichen Rauschanteile des Messignals bestehen im Rauschen der Strahlungsquelle mit sehr geringer Frequenz und dem Rauschen durch mechanische Schwingungen der optischen Komponenten im Strahlengang, deren Frequenz 100 Hz nicht wesentlich überschreitet. Ferner machen sich Empfindlichkeitsschwankungen p (t) der Photodiode bemerkbar, deren Frequenz ebenfalls nicht wesentlich grösser als 100 Hz ist. Die Modulationsfrequenz $f_M$ wird sehr viel grösser als die Signalfrequenz gewählt, die der Frequenz des zu messenden Stromes im Hochspannungsleiter entspricht und im allgemeinen 50 oder 60 Hz beträgt.

Berücksichtigt man alle zeitabhängigen Faktoren, so ergibt sich das vom Detektor abgegebene Signal aus

$$D = \frac{p(t) \cdot I(t)}{2} [1 + \sin 2 (F(t) + \Delta (t))]$$

mit F(t) als Winkel der Faraday-Drehung. Durch den Sinus in dieser Formel ist der lineare Zusammenhang zwischen Messgrösse und Messignal nicht mehr gegeben.

Für kleine Drehwinkel des Messignals bis zu etwa 3° kann der Sinus noch als linear angenommen werden. Wird ausserdem die Modulationsfrequenz $f_M$ sehr viel grösser als die Rauschfrequenz gewählt, so kann der Rauschanteil am Detektorsignal in der Elektronik eliminiert werden.

Zu diesem Zweck wird bei dem bekannten Verfahren das Detektorsignal sowohl einem Bandpass, der den Rauschanteil und die Modulatorfrequenz durchlässt und dem ein Demodulator nachgeschaltet ist, als auch einem Tiefpass zugeführt, der den Rauschanteil und die Frequenz der Faraday-Drehung durchlässt. Durch Division des Ausgangssignals des Tiefpasses durch das demodulierte Ausgangssignal des Bandpasses erhält man das rauschfreie Nutzsignal. Für grössere Winkel, bei denen man den Sinus nicht mehr als linear annehmen kann, ergeben sich in dieser Elektronik in den getrennten Frequenzbändern Mischglieder aus dem Nutzsignal und dem Modulationssignal, wodurch eine saubere Trennung von Rauschen und Nutzsignal nicht möglich ist.

Das Ziel des Modulationsverfahrens ist die Eliminierung des Rauschanteils am Messignal. Dies bedeutet aber, dass die Filterung im Band- und auch im Tiefpass mit derselben Charakteristik erfolgen muss, d.h. der Tiefpass muss so schmalbandig und steilflankig ausgeführt werden, wie der Bandpass, um Oberschwingungen zu vermeiden. Aber auch dann bleibt eine annähernd quadratisch mit der Signalamplitude ansteigende Nichtlinearität, die elektronisch linearisiert werden muss. Für grössere Drehwinkel erfordert deshalb die Elektronik einen verhältnismässig grossen Aufwand.

Der Erfindung liegt die Aufgabe zugrunde, das Messverfahren der eingangs genannten Art mit einem sinusförmigen Modulationssignal auch für grössere Winkel der Faraday-Drehung fehlerfrei zu machen. Diese Aufgabe wird erfindungsgemäss dadurch gelöst, dass aus dem Messignal getrennte Frequenzbänder mit der Grundfrequenz und der ersten Oberschwingung des Modulationssignals als jeweilige Mittelfrequenz herausgefiltert werden, dass anschliessend das Frequenzband mit der Oberschwingung und jenes mit der Grundfrequenz demoduliert und dann der Quotient aus den beiden Demodulationssignalen gebildet wird. Dieses Messverfahren hat den Vorteil, dass das Modulationssignal sinusförmig und die Modulationsdrehung kleiner als $\Pi/4$ sein kann. Damit erhält man auch einen einfachen Aufbau der Spannungsversorgung des Polarisationsmodulators.

Die Signalamplitude des Messignals D am Ausgang des Detektors 10 lässt sich in der Form einer Bessel'schen Reihe ausdrücken als

$$D = \frac{p(t) \cdot J(t)}{2} \left\{ 1 - \sum_{K=-\infty}^{+\infty} J_K \cdot (r\frac{\pi}{2}) \sin[K\,2\,\pi\,f_M\,t + 2\,F(t)] \right\}$$

wobei $J_k \cdot (r\frac{\pi}{2})$ die k-te Ordnung der Bessel-Funktionen 1. Art ist, und $0 \leqslant r \leqslant 1$ ist.

Von zwei Bandpässen lässt der erste die Grundfrequenz des Modulationssignals passieren. Als Signal ergibt sich dann

$$D_1 = D_{k=1} + D_{k=-1}$$

$$= -p(t) \cdot I(t) \cdot J_1(r\frac{\pi}{2})\cos 2\,F(t)\,\sin 2\,\pi f_M\,t$$

mit $p(t) \cdot I(t)$ als Rauschanteil und $J_1 \cdot (r\frac{\pi}{2})$ als Bessel-Funktion 1. Ordnung, 1. Art, in der $0 \leqslant r \leqslant 1$ ist, und mit $F(t)$ als Messignal.

Der zweite Bandpass lässt die erste Oberschwingung der Modulationsfrequenz passieren und man erhält

$$D_2 = D_{k=2} + D_{k=-2}$$

$$= -p(t) \cdot I(t) \cdot J_2(r\frac{\pi}{2}) \cdot \sin 2\,F(t) \cdot \sin 2\,\pi 2\,f_M\,t$$

mit $J_2 \cdot (r\frac{\pi}{2})$ als Bessel-Funktion 2. Ordnung, 1. Art.

Demoduliert man $D_1$ und $D_2$ und bildet dann den Quotienten, so erhält man

$$\frac{D_{2d}}{D_{1d}} = \frac{J_2(r\frac{\pi}{2})}{J_1(r\frac{\pi}{2})} \cdot \text{tg } 2\,F(t).$$

Solange die Faraday-Drehung kleiner als 90° ist, kann der Tangens linearisiert werden.

Eine weitere Möglichkeit besteht darin, dass man zunächst den Quotienten aus der 1. Oberschwingung der Modulationsfrequenz und der Grundfrequenz bildet

$$\frac{D_2}{D_1} = \frac{2\,J_2(r\frac{\pi}{2})}{J_1(r\frac{\pi}{2})} \cdot \text{tg } 2\,F(t) \cdot \cos 2\,\pi f_M t$$

und dann die Demodulation durchführt.

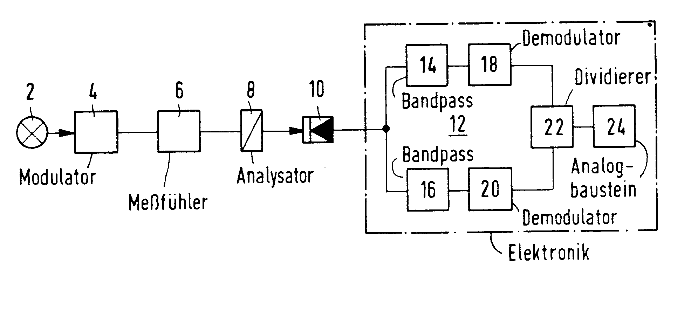

Ein Ausführungsbeispiel einer Anordnung zur Durchführung des Verfahrens nach der Erfindung ist in der Zeichnung als Blockschaltbild veranschaulicht.

In der Figur ist eine Strahlungsquelle mit 2, ein Modulator mit 4, ein Messfühler mit 6, ein Analysator mit 8 und ein Detektor mit 10 bezeichnet. Dem Detektor 10 ist eine Elektronik 12 nachgeschaltet, die zur Durchführung des Verfahrens nach der Erfindung in besonderer Weise gestaltet ist. Die Strahlungsquelle 2 liefert einen nicht näher bezeichneten Strahl polarisierten Lichts, vorzugsweise einen Laserstrahl, dessen Polarisationsrichtungen im Modulator 4 mit hoher Frequenz $f_M$ zwischen zwei Polarisationsrichtungen, die einen Winkel von 90° einschliessen, hin- und hergedreht werden. Die Modulationsfrequenz $f_M$ kann bei einem Messignal von 50 Hz vorzugsweise 10 kHz bis 100 kHz, insbesondere etwa 50 kHz, betragen.

Als Modulator 4 kann vorzugsweise ein elektrooptischer Modulator vorgesehen sein, der einen elektrooptischen Kristall enthält, dessen Doppelbrechung durch Anlegen einer Spannung verändert werden kann. Unter Umständen kann auch ein magnetooptischer Modulator zur Drehung der Polarisationsrichtung vorgesehen sein.

Zur Polarisierung des Lichtstrahls kann dem Modulator 4 auch ein in der Figur nicht dargestellter Polarisator vorgeschaltet sein, falls die Strahlungsquelle 2 kein linear polarisiertes Licht liefert.

Der Messfühler 6 dreht die Polarisationsrichtung zusätzlich in Abhängigkeit von der Grösse eines Magnetfeldes, das einen in der Figur nicht dargestellten elektrischen Leiter umgibt, dessen Strom gemessen werden soll. Der Analysator 8 wandelt die Polarisationsänderung in eine entsprechende Intensitätsänderung um, die von dem nachgeschalteten Detektor 10 erfasst wird, der vorzugsweise eine Halbleiter-Photodiode oder beispielsweise auch ein Photomultiplier sein kann. Vom Detektor 10 wird ein der Intensität der empfangenen Strahlung entsprechendes elektrisches Signal D abgegeben.

Das Ausgangssignal des Detektors 10 wird zwei Kanälen der Elektronik 12 mit jeweils einem Bandpass 14 bzw. 16 zugeführt, denen jeweils ein Demodulator 18 bzw. 20 nachgeschaltet ist. Der Bandpass 14 hat als Mittenfrequenz die Modulationsfrequenz $f_M$, und der Bandpass 16 hat die Mittenfrequenz $2 f_M$. Die Bandbreite der beiden Bandpässe 14 und 16 ist so gewählt, dass sich die beiden Bänder nicht überlappen. Der Demodulator 18 eliminiert die Modulationsfrequenz $f_M$ und der Demodulator 20 eliminiert die doppelte Frequenz $2 f_M$. ein Dividierer 2 dividiert die beiden demodulierten Signale $D_{2d}$ und $D_{1d}$. Da der Quotient

$$\frac{J_2\left(r\frac{\pi}{2}\right)}{J_1\left(r\frac{\pi}{2}\right)}$$

eine Konstante ist, bildet der Dividierer 22 eine dem Tangens des Signals der Faraday-Drehung proportionale Spannung. In einem Analogbaustein 24 wird der Tangens linearisiert.

Eine weitere Ausführungsform würde sich vom dargestellten Blockschaltbild dadurch unterscheiden, dass die Ausgangssignale der Bandpässe 14 und 16 dem gemeinsamen Dividierer 22 zur Quotientenbildung direkt zugeführt werden. Der Dividierer bildet dann den Quotienten aus der 1. Oberschwingung der Modulationsfrequenz $D_2$ und der Grundfrequenz $D_1$ und dann wird in einem dem Dividierer 22 nachgeschalteten gemeinsamen Demodulator die Demodulation des Quotientensignals durchgeführt.

## Patentansprüche

1. Verfahren zur magnetooptischen Strommessung mit einer vom Strom abhängigen Drehung der Polarisationsebene eines linear polarisierten Lichtstrahls, dem eine hochfrequente Modulationsdrehung überlagert wird, wobei die Gesamtdrehung in eine Intensitätsänderung des Lichtstrahls und diese wieder in ein elektrisches Messignal umgesetzt wird, dadurch gekennzeichnet, dass aus dem Messignal getrennte Frequenzbänder mit der Grundfrequenz und der ersten Oberschwingung des Modulationssignals als jeweiliger Mittenfrequenz herausgefiltert werden, dass anschliessend das Frequenzband mit der Oberschwingung und jenes mit der Grundfrequenz demoduliert und dann der Quotient aus den beiden Demodulationssignalen gebildet wird.

2. Verfahren zur magnetooptischen Strommessung mit einer vom Strom abhängigen Drehung der Polarisationsebene eines linear polarisierten Lichtstrahls, dem ein hochfrequentes Modulationssignal überlagert wird und das demoduliert und gefiltert wird, dadurch gekennzeichnet, dass aus dem Messignal getrennte Frequenzbänder mit der Grundfrequenz und der ersten Oberschwingung des Modulationssignals als jeweiliger Mittenfrequenz herausgefiltert werden, dass anschliessend der Quotient aus dem Signal des Frequenzbandes mit der Oberschwingung und jenem des Frequenzbandes mit der Grundschwingung gebildet und dann das Quotientensignal demoduliert wird.

## Claims

1. A method of magneto-optical current measurement utilising that rotation of the polarisation plane of a linearly polarised light beam which is dependent upon the current and on which is superimposed a high-frequency modulating rotation, the total rotation being converted into a change in intensity of the light beam, and this change being converted into an electric measuring signal, characterised in that separate frequency bands having the fundamental frequency and the first harmonic of the modulation signal as respective centre frequencies are filtered from the measuring signal, the frequency band of the harmonic and that of the fundamental frequency being subsequently demodulated, and the quotient of the two demodulation signals then being formed.

2. A method of magneto-optical current measurement utilising that rotation of the polarisation plane of a linearly polarised light beam which is dependent upon the current and on which is superimposed a high-frequency modulating rotation, the total rotation being converted into a change in intensity of the light beam, and this change being converted into an electric measuring signal, characterised in that separate frequency bands having the fundamental frequency and the first harmonic of the modulation signal as respective centre frequencies are filtered from the measuring signal, a quotient is formed of the signals of the frequency band of the harmonic and of the frequency band of the fundamental, and the quotient signal then demodulated.

## Revendications

1. Procédé pour la mesure magnétooptique d'un courant, avec une rotation du plan de polarisation, en fonction du courant, d'un rayon lumineux polarisé linéairement, auquel on superpose une rotation de modulation haute fréquence, la rotation totale étant transformée en une variation de l'intensité du rayon lumineux et celle-ci étant à son tour transformée en un signal de mesure électrique, caractérisé par le fait que sous forme de fréquences moyennes respectives, on filtre du signal de mesure des bandes de fréquence séparées avec la fréquence fondamentale et le premier harmonique du signal de modulation, qu'ensuite la bande de fréquence contenant l'harmonique et celle contenant la fréquence fondamentale sont démodulées alors qu'on procède après à l'établissement du quotient des deux signaux de démodulation.

2. Procédé pour la mesure magnétooptique avec une rotation du plan de polarisation, en fonction du courant, d'un rayon lumineux polarisé linéairement, auquel est superposée une rotation de modulation haute fréquence, la rotation totale étant transformée en une variation de l'intensité du rayon lumineux, cette dernière étant à son tour transformée en un signal électrique, caractérisé par le fait que l'on filtre sous forme de fréquence moyenne, à partir du signal de mesure, des bandes de fréquences séparées contenant respectivement la fréquence fondamentale et le premier harmonique du signal de modulation, que l'on forme ensuite le quotient entre le signal de la bande de fréquence contenant l'harmonique et le signal de la bande de fréquence contenant l'oscillation fondamentale, puis on démodule le signal représentatif du quotient.